Europäisches Patentamt

**European Patent Office**

Office européen des brevets

(11) Publication number: **0 110 701**

**B1**

(12) **EUROPEAN PATENT SPECIFICATION**

(45) Date of publication of patent specification: **30.09.87**

(51) Int. Cl.⁴: **H 03 K 19/094**

(21) Application number: **83307239.0**

(22) Date of filing: **28.11.83**

(54) **Input buffer circuit.**

(30) Priority: **27.11.82 JP 208301/82**

(43) Date of publication of application:
**13.06.84 Bulletin 84/24**

(45) Publication of the grant of the patent:
**30.09.87 Bulletin 87/40**

(84) Designated Contracting States:
**DE FR GB**

(56) References cited:
**EP-A-0 042 777**
**EP-A-0 102 643**
**FR-A-2 230 125**
**GB-A-1 447 476**
**US-A-4 242 604**

**PATENTS ABSTRACTS OF JAPAN, vol. 6, no.
123 (E-117)1001r, 8th July 1982**

(73) Proprietor: **HITACHI, LTD.**
**6, Kanda Surugadai 4-chome Chiyoda-ku
Tokyo 100 (JP)**

(72) Inventor: **Masuda, Noboru
4-14-6, Nishi-Koigakubo
Kokubunji-shi Tokyo (JP)**
Inventor: **Asano, Michio
6-13-17, Higashi-Koigakubo
Kokubunjo-shi Tokyo (JP)**
Inventor: **Hayashi, Takehisa
4-14-6, Nishi-Koigakubo
Kokubinji-shi Tokyo (JP)**
Inventor: **Tanaka, Hirotoshi
2-32-C307, Koyasu-cho
Hachioji-shi Tokyo (JP)**
Inventor: **Masaki, Akira
1-16-13-508, Megurohoncho
Meguro-ku Tokyo (JP)**

(74) Representative: **Ellis, Edward Lovell et al
MEWBURN ELLIS & CO. 2/3 Cursitor Street
London EC4A 1BQ (GB)**

# 0 110 701

**Description**

The present invention relates to input buffer circuits and more particularly to an input buffer circuit for a digital integrated circuit of FETs which can receive ECL level signals.

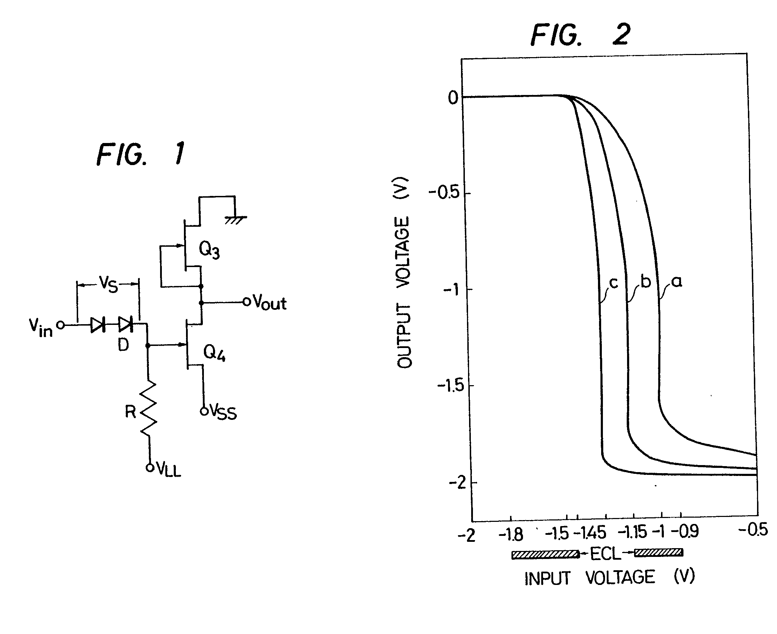

Figure 1 of the accompanying drawings shows by way of example a known input buffer circuit of a digital integrated circuit constructed of FETs (field effect transistors).

This circuit comprises an inverter which consists of normally "on" type FETs $Q_3$ and $Q_4$, and a level shifting circuit which consists of diodes D and a resistor R. The level shifting circuit shifts an input level $V_{in}$ in order to convert it into a voltage level capable of switching the inverter of the succeeding stage, that is, a transition logic level.

Figure 2 of the accompanying drawings is a graph of transfer characteristics in Figure 1. Curves $a$, $b$, and $c$ indicate cases where the ratio $W_4/W_3$ between the gate widths of the FETs $Q_3$ and $Q_4$ is set at 5, 13 and 50, respectively. This graph illustrates the case where a supply voltage $V_{ss}$ is set at $-2$ V, the threshold voltage $V_T$ of the FET at $-1$ V and the level shift magnitude $V_s$ of the diodes D at 1.55 V.

As illustrated in Figure 2, with the input buffer of Figure 1, an input logic swing required for satisfactorily switching the output may be smaller as the ratio between the gate width $W_4$ of the FET $Q_4$ and the gate width $W_3$ of the FET $Q_3$ is greater. Here, assuming the input signal of an ECL (Emitter Coupled Logic) level, the output of the inverter needs to be satisfactorily switched in a range of signal levels from $-1.45$ V to $-1.15$ V. It will be noted from Figure 2 that $W_4/W_3$ needs to be at least 13 in order to satisfy the above specification.

In this respect, the input buffer of Figure 1 has the following two disadvantages:

(a) In the case where the threshold voltage $V_T$ of the FET has fluctuated due to dispersions in manufacturing conditions etc., the input logic swing necessary for reliably switching the output increases.

(b) Also in the case where the supply voltage $V_{ss}$ has fluctuated, the input logic swing necessary for reliably switching the output increases.

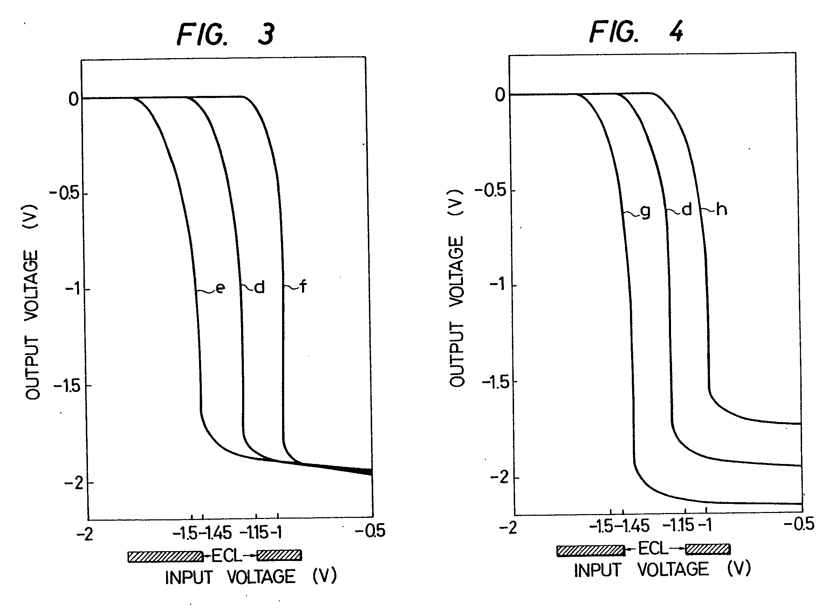

Figure 3 of the accompanying drawing is a graph of the transfer characteristics in the case where the threshold voltage $V_T$ has fluctuated in the circuit of Figure 1, whilst Figure 4 of the accompanying drawings is a graph of transfer characteristics in the case where the supply voltage $V_{ss}$ has fluctuated in the same circuit. In Figures 3 and 4, a curve $d$ indicates the transfer characteristic obtained for values of a threshold voltage $V_T=-1$ V and a supply voltage $V_{ss}=-2$ V in the case of $W_4/W_3=13$, and it is the same curve as the curve $b$ shown in Figure 2. Curves $e$ and $f$ in Figure 3 indicate the transfer characteristics obtained when the supply voltage $V_{ss}$ is at a value ($V_{ss}=-2$ V) and the threshold voltage $V_T$ has become $-1.3$ V and $-0.7$ V, respectively. Curves $g$ and $h$ in Figure 4 indicate the transfer characteristics obtained when the threshold voltage $V_T$ is at a value ($V_T=-1$ V) and the supply voltage $V_{ss}$ has become $-2.2$ V and $-1.8$ V, respectively. In any case, the input necessary for reliably switching the output is about $-1.6$ V as a low level and about $-0.9$ V as a high level, that is, the logic swing becomes about 0.7 V.

This value is approximately double that of the input logic swing 0.3 V which is originally required in the absence of any fluctuation, and it becomes a serious problem. The value of 0.7 V corresponds to the addition of about 0.4 V which is the width of the change of the input logic threshold value of the inverter, the change being attributed to the fluctuation of the threshold voltage $V_T$ or the supply voltage $V_{ss}$. In the case where the fluctuations of the threshold voltage $V_T$ and the supply voltage $V_{ss}$ have simultaneously occurred, a further additional input logic swing of 1.1 V with 0.4 V is required. Meanwhile, when the gate width ratio $W_4/W_3$ is set to be smaller, the influence of the fluctuation of the threshold voltage $V_T$ is somewhat mitigated, but the input logic swing originally required increases as stated before. It can accordingly be said that, in the presence of the manufacture dispersion or the supply voltage fluctuation, the signal of the ECL level cannot be received by the circuit of Figure 1.

Although the case of using the normally "on" type FETs has thus far been described, a similar problem arises also in a circuit employing normally "off" type FETs.

In addition to the above known input buffer circuit disclosed in Figure 1, other known input buffer circuits are disclosed in FR—A—2,230,125, GB—1,447,476 and US—A—4,242,604.

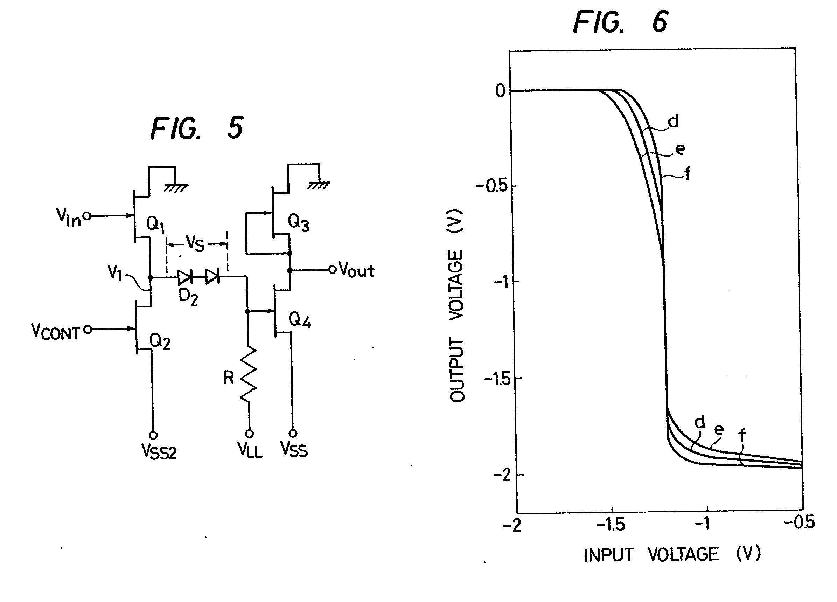

FR—A—2,230,125 discloses in Figure 5 a particular application of a voltage regulation system which comprises a resistance and saturable resistance in series across which a fixed potential is applied. In Figure 5, a diode connected transistor T1 constituting the saturable resistance is connected in series with a resistor R constituting said resistance and a transistor T2 across a predetermined potential. Series connected transistors T3 and T4 are connected between the source of fixed potential ($+V1$) and earth. The output from the circuit is taken from the junction between the two transistors T3 and T4, and the base of T4 is connected to the junction between the resistance R and diode connected transistor T1. The input is applied to the base of the transistor T2. In operation when a logic level 1 is applied to the gate of the transistor T2, its source has a potential substantially equal to E. A constant current flows through the resistance R and a potential of $V=E-e$ is applied to the gate of the transistor T4. Under these conditions, the output voltage level at the output S is substantially zero. The circuit thus acts as an inverter. Likewise, an inverting function is achieved when a logic level 0 is applied to the base of the transistor T2. In this case a high negative voltage is applied to the gate of the transistor T4 which is rendered non-conductive, so that the output voltage level at the output S becomes substantially equal to the voltage $+V1$ representing a logic level 1.

GB—1,447,476 discloses a semiconductor circuit arrangement having a plurality of inverting stages

2

and a sample inverting stage. Each inverting stage includes an inverting semiconductor device and a load semiconductor device. The sample inverting stage includes means for degrading a logic level signal derived therefrom and a regulator associated with the load device for varying its conductance by means of a control signal applied to counteract the degradation. The control signal is also applied to the load device of one or more of the other inverting stages for logic level connection purposes.

US—A—4,242,604 discloses an integrated buffer circuit having a selectable stabilized trip voltage, which circuit includes an input stage and a reference stage. Each of these stages includes a MOS field effect transistor, a substantially constant resistance device coupling the drain of the input transistor to a bias source, and a device having a resistance which is variable in response to control signals coupling the source of the input transistor to another bias source. A signal generated at the drain of the transistor in the reference stage is connected to all the variable resistance devices as the control signal. This signal varies the variable resistance in such a way as to compensate for threshold voltage variations in the transistor of the input stage and thus stabilize the selected trip voltage of the input stage.

It is an object of the present invention to overcome the above referred to disadvantages and thus provide an input buffer circuit whose buffer output signal is less affected by a manufacturing dispersion or a supply voltage fluctuation, without substantial increase in power consumption or delay time.

According to the present invention there is provided an input buffer circuit comprising an inverter circuit; a source follower circuit having first and second FETs of an identical conductivity type whose source-drain paths are connected in series, the gate of said first FET being connected to a circuit input for receiving the input signal, the output of the source follower circuit being connected to the inverter circuit either directly or through a level shift circuit, characterized in that a control voltage is supplied to the gate of said second FET in said source follower circuit to control a transition logic level of said source follower circuit in order to compensate for fluctuations of the input logic threshold of the inverter circuit due to fluctuations of the threshold voltage and/or fluctuations of the supply voltage.

The present invention will now be described in greater detail by way of example with reference to the remaining figures of the accompanying drawings.

Figure 5 is a circuit diagram showing an embodiment of an input buffer circuit according to the present invention;

Figures 6 and 7 are graphs of the transfer characteristics of the circuit in Figure 5;

Figure 8 is a circuit diagram of a control circuit showing an embodiment of the present invention;

Figure 9 is a block diagram showing an example of connection between the input buffer circuit of Figure 5 and the control circuit of Figure 8;

Figures 10, 11, 12, 13, 14, 15, 16 and 17 are circuit diagrams of input buffer circuits each showing another embodiment of the present invention; and

Figure 18 is an arrangement diagram of a control circuit showing another embodiment of the present invention.

Referring to Figure 5, the input buffer circuit includes first, second, third and fourth FETs, $Q_1$, $Q_2$, $Q_3$ and $Q_4$ respectively, and diodes $D_2$ and a resistor R for level shift. Symbols $V_{SS}$, $V_{SS2}$ and $V_{LL}$ indicate supply voltages, and symbols $V_{in}$, $V_{out}$ and $V_{cont}$ indicate voltages at an input terminal, output terminal and control voltage input terminal, respectively. The FETs $Q_3$ and $Q_4$ constitute an inverter, and the diodes $D_2$ and the resistor R constitute a level shifting circuit, these elements forming the same circuit as in the prior-art input buffer shown in Figure 1. In addition, the FETs $Q_1$ and $Q_2$ constitute a source follower circuit. Unlike an ordinary source follower circuit, this source follower circuit features that current flowing therethrough can be controlled with the voltage fed to the control voltage input terminal $V_{cont}$.

In this embodiment, for the sake of convenience, the level shift magnitude of the diodes $D_2$ will be designated by $V_S$, the source voltage of the FET $Q_1$ by $V_1$, and the gate widths of the FETs $Q_1$—$Q_4$ by $W_1$—$W_4$ respectively. In order to simplify the description, it is assumed that all the FETs are of the N-channel type and that all the threshold voltages thereof are equal and are $V_T$ ($V_T<0$). It is also assumed that the supply voltage $V_{SS2}$ and the threshold voltage $V_T$ are selected so as to operate the FETs $Q_1$ and $Q_2$ constituting the source follower, in their saturation regions at all times.

The operation input buffer of the circuit shown in Figure 5 will now be described.

Since the saturation condition holds for the FETs $Q_1$ and $Q_2$ constituting the source follower, the relationship of $V_{in}$ $V_1$, $V_{cont}$ and $V_{SS2}$ becomes as follows:

$$W_1(V_{in}-V_1-V_T)^2=W_2(V_{cont}-V_{SS2}-V_T)^2$$

$$V_1=V_{in}-V_T(1-\sqrt{\frac{W_2}{W_1}})-\sqrt{\frac{W_2}{W_1}}(V_{cont}-V_{SS2}) \qquad (1)$$

That is, $V_1$ becomes a voltage obtained by converting the level of the input voltage $V_{in}$ by a certain value which is determined by $V_T$, $V_{SS2}$ and $V_{cont}$.

On the other hand, the FETs $Q_3$ and $Q_4$ constituting the inverter are both saturated when the output voltage $V_{out}$ becomes the transition logic level. Letting $V_{1TH}$ denote the value of $V_1$ at this time, namely, the input logic threshold value of the inverter, the following equation is derived:

3

$$W_3(-V_T)^2 = W_4(V_{1TH}-V_S-V_{SS}-V_T)^2$$

Accordingly, $V_{1TH}$ is given by the following equation:

$$V_{1TH}=V_S+V_{SS}+V_T(1-\sqrt{\frac{W_3}{W_4}}) \tag{2}$$

Letting $V_{inTH}$ denote the value of $V_{in}$ at this time, namely, the input logic threshold value of the circuit of Figure 5, the following is obtained from equations (1) and (2):

$$V_{inTH}=V_{SS}+V_S+V_T(2-\sqrt{\frac{W_3}{W_4}}-\sqrt{\frac{W_2}{W_1}}) + \sqrt{\frac{W_2}{W_1}}(V_{cont}-V_{SS2}) \tag{3}$$

As apparent from equation (3), $V_{inTH}$ can be set at a desired value by selecting the control voltage $V_{cont}$ as follows:

$$V_{cont}=V_{SS2}+\sqrt{\frac{W_1}{W_2}}\{V_{inTH}-V_{SS}-V_S -V_T(2-\sqrt{\frac{W_3}{W_4}}-\sqrt{\frac{W_2}{W_1}})\} \tag{4}$$

Accordingly, in the case where $V_{SS}$, $V_{SS2}$ and $V_T$ have fluctuated; when the control voltage $V_{cont}$ is changed in accordance with equation (4) for the preset threshold value $V_{inTH}$, a circuit whose transition logic level does not fluctuate is realized, and the object of the present invention can be accomplished. A method of generating this control voltage $V_{cont}$ will be described later.

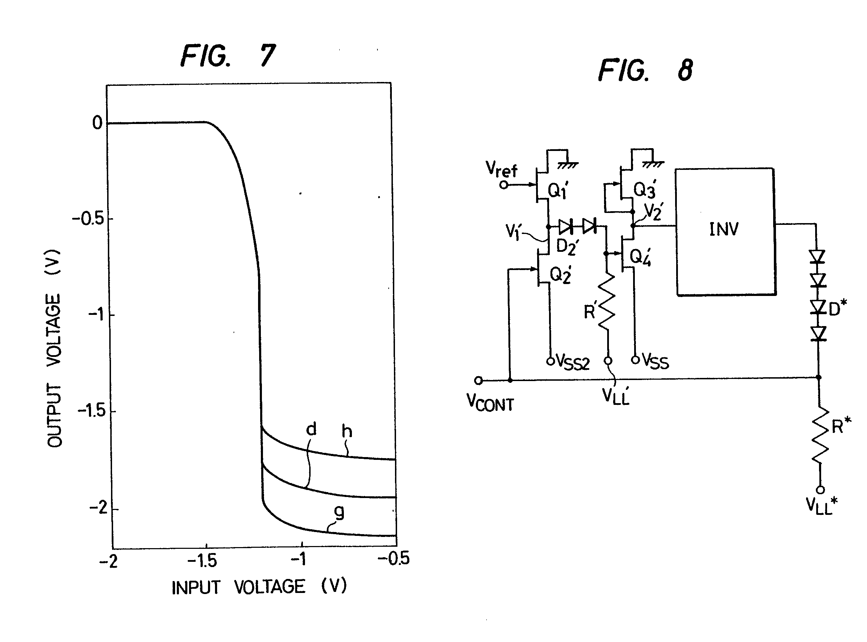

Figures 6 and 7 are graphs of the transfer characteristics of the circuit in Figure 5, respectively.

In Figures 6 and 7, curves $d$ indicate the transfer caracteristic at design values, that is, at $V_T=-1$ V and $V_{SS}=-2$ V. Curves $e$ and $f$ in Figure 6 indicate the transfer characteristics in the cases where the threshold voltage $V_T$ has become $-1.3$ V and $-0.7$ V, respectively, and curves $g$ and $h$ in Figure 7 the transfer characteristics in the cases where the supply voltage $V_{SS}$ has become $-2.2$ V and $-1.8$ V, respectively. Herein, the other constants are $W_4/W_3=13$, $W_2/W_1=3$, $V_S=1.55$ V and $V_{inTH}=-1.2.$V. It is understood that, in any case, the output signal is substantially perfectly switched when the input signal has changed from $-1.45$ V to $-1.15$ V. The above corresponds to the case where all the threshold voltages $V_T$ of the FETs are assumed to be equal. However, even in the case where the threshold voltages $V_T$ are not equal, the same effect can be attained by giving $V_{cont}$ as follows:

$$V_{cont}=V_{SS2}+V_{T2}+\sqrt{\frac{W_1}{W_2}}(V_{inTH}-V_{SS}-V_S -V_{T4}-V_{T1}+\sqrt{\frac{W_3}{W_4}}\cdot V_{T3}) \tag{5}$$

where $V_{T1}$, $V_{T2}$, $V_{T3}$ and $V_{T4}$ denote the threshold voltages of the FETs $Q_1$, $Q_2$, $Q_3$ and $Q_4$, respectively.

A control circuit for generating the control voltage $V_{cont}$ given by equation (4) or equation (5) will now be described with reference to Figure 8.

Referring to Figure 8, the control circuit includes first, second, third and fourth FETs, $Q_1'$, $Q_2'$, $Q_3'$ and $Q_4'$ respectively, and divides $D_2$ and a resistor R for level shift. Portions constructed of these elements are identical in arrangement to the input buffer of Figure 5, except that the gate of the FET $Q_1'$ is supplied with a reference voltage $V_{ref}$ instead of the input voltage $V_{in}$. The circuit also includes an inverter circuit INV. The input logic threshold voltage of this inverter circuit INV is designed so as to become a value close to the logic threshold voltage of the output $V_{out}$ of the circuit in Figure 5. In addition, the circuit includes diodes D, a resistor R* and a supply voltage $V_{LL}^*$, these elements constituting a level shifting circuit for adjusting the output level of the inverter circuit INV to the level of the control voltage $V_{cont}$. The output $V_{CONT}'$ of the level shifting circuit is connected to the gate electrode of the FET $Q_2'$ so as to apply feedback. The output $V_{CONT}'$ is also a terminal for deriving the control voltage, and it is connected to the control voltage terminal $V_{cont}$ of the input buffer in Figure 5.

In order to simplify the description, it is assumed that the portions having the same arrangements as in Figure 5 are given quite the same device constants and circuit constants as in Figure 5, and the fixed voltage $V_{inTH}$ is applied as the reference voltage $V_{ref}$. The operation of this control circuit will be described below.

It is now supposed that the voltage $V_{CONT}'$ is equal to the potential $V_{cont}$ which fulfills the condition given by equation (4) or equation (5). At this time, the inverter composed of the FETs $Q_3'$ and $Q_4'$ falls into its threshold state. Thus, when a potential $V_1'$ has fluctuated even if slightly, the output voltage of the inverter, namely, the input voltage $V_2'$ of the inverter INV fluctuates greatly.

Next, it is assumed that the control voltage $V_{CONT}'$ has become somewhat higher than $V_{cont}$. Then, current flowing through the N-channel FET $Q_2'$ increases to lower $V_1'$ and to raise $V_2'$, so that the output of the inverter INV becomes close to the low level. Thus, the control voltage $V_{CONT}'$ lowers.

That is, the control circuit of Figure 8 forms a feedback circuit which functions in the direction of lowering $V_{CONT}'$ when this voltage has risen. Accordingly, when the control voltage $V_{CONT}$ has conversely become somewhat lower, the output of the inverter INV functions in the direction of raising the control voltage $V_{CONT}'$. In this way, the control voltage $V_{CONT}'$ settles to a value close to $V_{cont}$, so that the control voltage stable against the fluctuations of the threshold voltage $V_T$ and the supply voltage $V_{SS}$ can be attained.

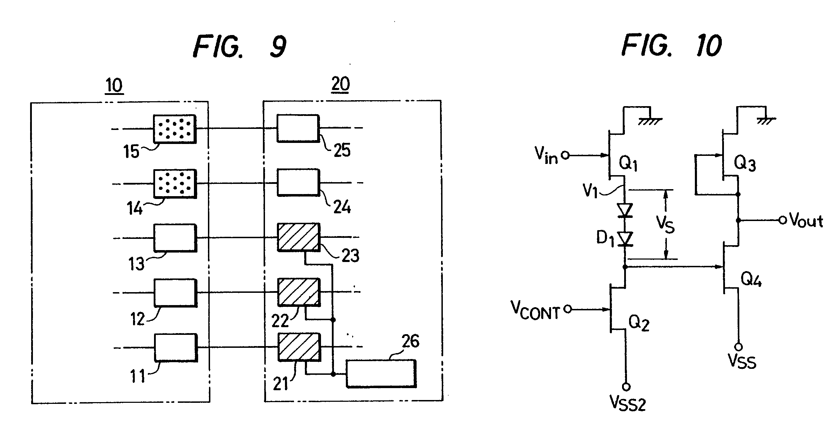

Figure 9 is a block diagram showing an embodiment in the case of where the control circuit of Figure 8 is connected to a plurality of input buffers of Figure 5. In this manner the control circuit can also supply a control voltage to a plurality of input buffers. The circuit shown in block form in Figure 9 includes an ECL LSI, 10 and a FET LSI 20. The circuit further includes output buffers 11, 12 and 13 within the ECL LSI 10, input buffers 14 and 15 within the ECL LSI *10*, input buffers 21, 22 and 23 being the same as the one shown in Figure 5, these input buffers being within the FET LSI 20, output buffers 24 and 25 within the FET LSI 20, and a control circuit 26 being the same as that shown in Figure 8.

It has been described that, in Figure 8 or the control circuit, the portions having the same arrangements as in Figure 5 or the input buffer are substantially the same circuits. However, when the following conditions hold, that is, when the portions in both the figures are similar with respect to currents, these portions need not be quite the same:

$$V_{T1}, V_{T2}, V_{T3}, V_{T4}, W_1/W_2, W_3/W_4 \text{ (Figure 5)}$$

$$= V_{T1}', V_{T2}', V_{T3}', V_{T4}', W_1'/W_2', W_3'/W_4' \text{ (Figure 8)} \tag{6}$$

In this case, the level shift magnitudes of the diodes $D_2$ in Figure 5 and the diodes $D_2'$ in Figure 8 need not be equal to each other. When they are not equal, a voltage obtained by subtracting the difference of the level shift magnitudes from the voltage $V_{inTH}$ may be applied as the reference voltage $V_{ref}$. It is impossible to make the threshold voltages $V_T$ of the respective FETs quite equal. However, as regards the dispersion of the threshold voltages $V_T$ of FETs which are simultaneously manufactured within a single LSI chip, relative fluctuations can be made smaller than absolute fluctuations from a design value. In addition, the input logic threshold value of the inverter INV has been set at a value close to the transition logic level of the output voltage $V_{out}$ of the circuit in Figure 5. However, insofar as it lies between the low level and high level of the output voltage of the circuit in Figure 5, the fluctuation of the supply voltage is amplified to change the control voltage $V_{CONT}'$, and the inverter INV operates as described above. When this condition is fulfilled, the constituent circuits of the inverter INV and the number of constituent stages thereof and the kinds of power sources to be used may be chosen anyhow. Further, it is sometimes the case that the number of the diodes D* changes depending upon the output levels of the inverter INV. In some cases, the output of the inverter INV is directly connected to the control voltage $V_{CONT}'$ and the gate of the FET $Q_2'$, to dispense with the diodes D*, resistor R* and supply voltage $V_{LL}*$, or the sense of the diodes D* becomes the opposite.

In the circuits of Figures 5 and 8, the supply voltages $V_{SS}$ and $V_{SS2}$ or the supply voltages $V_{LL}$ and $V_{LL}'$, $V_{LL}*$ may well be equalized.

Figures 10, 11, 12, 13, 14, 15, 16 and 17 are arrangement diagrams of input buffers each showing further embodiments of the present invention.

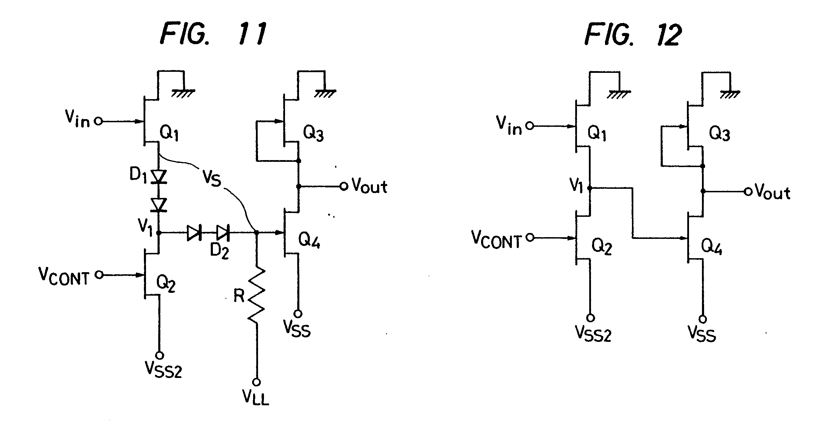

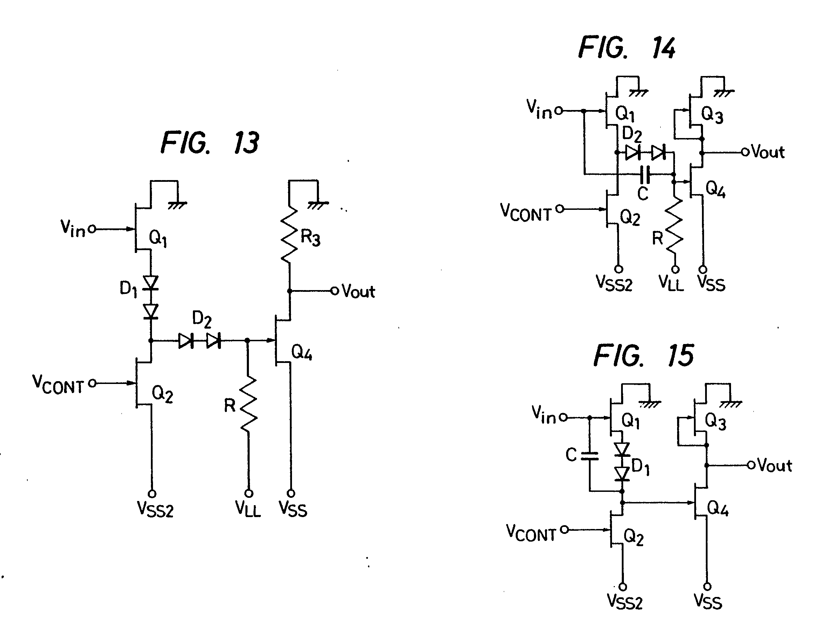

The embodiment of Figure 10 is such that, in the arrangement of Figure 5, the level shifting circuit composed of the diodes $D_2$, resistor R and voltage source $V_{LL}$ is replaced with diodes $D_1$ connected in series between the FETs $Q_1$ and $Q_2$, so as to derive the output of the source follower circuit from between the diodes $D_1$ and the FET $Q_2$ and to supply it to the inverter circuit of the succeeding stage. The embodiment of Figure 11 is such that, in the arrangement of Figure 5, diodes $D_1$ are further connected in series between the FETs $Q_1$ and $Q_2$, so as to derive the output of the source follower circuit from between the diodes $D_1$ and the FET $Q_2$ and to supply it to the inverter circuit of the succeeding stage through the diodes $D_2$. The embodiment of Figure 12 is such that, in the arrangement of Figure 5, the level shifting circuit composed of the diodes $D_2$, resistor R and voltage source $V_{LL}$ is omitted so as to directly supply the inverter circuit of the succeeding stage with the output of the source follower circuit derived from between the FETs $Q_1$ and $Q_2$. The embodiment of Figure 13 is such that, in the arrangement of Figure 11, the FET $Q_3$ is replaced with a resistor $R_3$. The embodiments of Figure 14, 15, 16 or 17 are such that, in the arrangements of Figure 5, 10, 11 or 12, a coupling capacitor C is connected between the input end $V_{in}$ (the gate electrode of the FET $Q_1$) of the source follower circuit and the input end (the gate electrode of the FET $Q_4$) of the inverter circuit, respectively.

The effect of the present invention is similarly achieved even when the circuit of Figure 5 or the same constituent portions in Figure 8 as in Figure 5 is/are replaced with the circuit shown in Figure 10, 11, 12, 13, 14, 15, 16 or 17. The circuit to be used as the input buffer, and the circuit to be used as a part of the control circuit can be selected from among Figures 5, 10, 11, 12, 13, 14, 15, 16 and 17 independently of each other. At this time, the relations to be met by the FET device constants and circuit constants of the circuit for use as the input buffer and the circuit for use as a part of the control circuit are the same as the relations of equation (6) mentioned before:

**0 110 701**

$$V_{T1}, V_{T2}, V_{T3}, V_{T4}, W_1/W_2, W_3/W_4 \text{ (input buffer)}$$

$$= V_{T1}', V_{T2}', V_{T3}', V_{T4}', W_1'/W_2', W_3'/W_4' \text{ (control circuit)} \tag{7}$$

In this case, the description thus far made holds as it is by considering the voltage drop $V_s$ to be the level shift magnitude of the diodes $D_1$ for the circuit of Figure 10, to be the sum of the level shift magnitudes of the diodes $D_1$ and $D_2$ for the circuit of Figure 11, and to be 0 V for the circuit of Figure 12. It is a matter of course that the number of diodes $D_1$ or $D_2$ in Figure 5, 10, 11, 14, 15 or 16 may be any number of at least one.

The effect of the present invention applies even when the resistor $R_3$ is substituted for the FET $Q_3$ in Figure 5, 10, 11 or 12. While the circuit of Figure 13 is the example of substitution for the circuit of Figure 11, similar substitutions for the circuits of Figures 5, 10 and 12 are possible. The substitutions are performed ·for both the input buffer and the control circuit, and the conditions of equation (7) become as follows:

$$V_{T1}, V_{T2}, V_{T4}, W_1/W_2, R_3 \times W_4 \text{ (input buffer)}$$

$$= V_{T1}', V_{T2}', V_{T4}', W_1'/W_2', R_3' \times W_4' \text{ (control circuit)} \tag{8}$$

In the case where the circuit without any substitution has the following conditions:

$$V_{T1} = V_{T2} = V_{T3} = V_{T4}$$

and

$$\sqrt{W_3/W_4} + \sqrt{W_2/W_1} = 2 \tag{9}$$

the control voltage $V_{cont}$ given by equation (4) becomes independent of the threshold voltage $V_T$, as follows:

$$V_{cont} = V_{SS2} + \sqrt{\frac{W_1}{W_2}}(V_{InTH} - V_{SS} - V_s) \tag{10}$$

Since the four FETs $Q_1$, $Q_2$, $Q_3$ and $Q_4$ in one input buffer can be brought closer than the distance between the input buffer and the control circuit, the dispersion of the threshold voltages $V_T$ can be made still smaller than in the case of the conditions of equation (6). Accordingly a more remarkable effect can be expected.

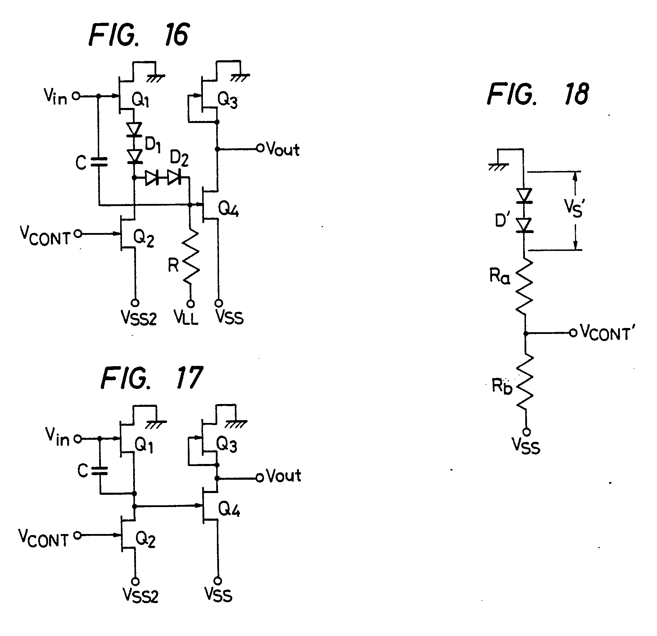

Figure 18 is an arrangement diagram showing another embodiment of the control circuit portion of the present invention.

When the supply voltages $V_{SS}$ and $V_{SS2}$ are equal and fluctuate little, it is also possible to employ the control circuit of simple arrangement as shown in Figure 18, in which level shifting diodes D' and resistors $R_a$ and $R_b$ are connected in series so as to derive the control voltage $V_{CONT}'$ from between the resistors $R_a$ and $R_b$.

In Figure 18, in the case where the ratio of the resistances $R_a$ and $R_b$ is set so that $R_a/R_b = \sqrt{W_2/W_1} - 1$ may hold and where the number of the diodes D' and the values of the resistances $R_a$ and $R_b$ are determined so that the level shift magnitude $V_s'$ of the diodes D' may become equal to $(V_s - V_{InTH})$ in Equation (10), the control voltage $V_{CONT}'$ becomes as follows:

$$V_{CONT}' = (1 - \sqrt{\frac{W_1}{W_2}}) V_{SS} + \sqrt{\frac{W_1}{W_2}}(V_{InTH} - V_s) \tag{11}$$

Equation (11) agrees with $V_{cont}$ resulting when $V_{SS2} = V_{SS}$ is assumed in equation (10).

Any of the level shifting resistors R used in the various embodiments, except the simple control circuit shown in Figure 18, can be replaced with any desired current limiter. One example is a FET whose source electrode and gate electrode are connected in common.

Further, although all the FETs used in the respective embodiments have been of the N-channel, they all may well be P-channel FETs, with the polarities of the diodes and the supply voltages reversed.

When, as shown in Figure 14, 15, 16 or 17, the coupling capacitor C is connected between the input terminal $V_{in}$ and the gate electrode of the FET $Q_4$, increase in the delay time can be reduced. Needless to say, the connection of such coupling capacitor C is also applicable to circuits in which the FET $Q_3$ is replaced with the resistor as shown in Figure 13.

With some constants selected, the control circuit is feared to oscillate. For avoiding this drawback, it is effective to connect a capacitor between the terminal of the control voltage $V_{CONT}'$ and the power source.

While, in the embodiments, the case of receiving the signal of the ECL level has been stated, a signal of any desired level can be received by altering the voltage to be applied as the reference voltage $V_{ref}$ of the control circuit.

As described above, the present invention can realize an input buffer less susceptible to manufacturing

6

dispersions or supply voltage fluctuations, without increasing power consumption or delay time. Therefore, the invention is very effective when applied to any sort of FET integrated circuit such as GaAs MESFETs or Si MOS devices.

**Claims**

1. An input buffer circuit comprising an inverter circuit ($Q_3$, $Q_4$); a source follower circuit having first and second FETs ($Q_1$, $Q_2$) of an identical conductivity type whose source-drain paths are connected in series, the gate of said first FET ($Q_1$) being connected to a circuit input for receiving the input signal ($V_{in}$), the output of the source follower circuit being connected to the inverter circuit ($Q_3$, $Q_4$) either directly or through a level shift circuit ($D_2$, R), characterized in that a control voltage ($V_{cont}$) is supplied to the gate of said second FET ($Q_2$) in said source follower circuit to control a transition logic level of said source follower circuit in order to compensate for fluctuations of the input logic threshold ($V_{inTH}$) of the inverter circuit due to fluctuations of the threshold voltage ($V_{TH}$) and/or fluctuations of the supply voltage ($V_{SS}$).

2. An input buffer circuit according to claim 1, characterized in that said level shift circuit comprises at least one diode ($D_1$) which is connected in series between said first and second FETs ($Q_1$, $Q_2$).

3. An input buffer circuit according to claim 1 or 2, characterized in that said level shift circuit comprises at least one diode ($D_2$) which is connected between the output of said source follower circuit ($Q_1$, $Q_2$) and the input of said inverter circuit ($Q_3$, $Q_4$).

4. An input buffer circuit according to any one of the preceding claims, characterized in that said FET inverter circuit includes a first load element and a fourth FET ($Q_4$) which are connected in series, the gate of said fourth FET receiving the output of said source follower circuit ($Q_1$, $Q_2$) and an output is provided from between said first load element and said fourth FET ($Q_4$).

5. An input buffer circuit according to claim 4, characterized in that said first load element is a third FET ($Q_3$) whose source and gate are connected in common.

6. An input buffer circuit according to claim 5, characterized in that the respective FETs which constitute said source follower circuit ($Q_1$, $Q_2$), and said FET inverter circuit ($Q_3$, $Q_4$) have equal threshold voltages, and the sum between the square root of a gate width ratio of said first and second FETs ($Q_1$, $Q_2$) of said source follower circuit and the square root of an inverse number of a gate width ratio of said third and fourth FETs ($Q_3$, $Q_4$) of said FET inverter circuit is approximately 2.

7. An input buffer circuit according to claim 4, characterized in that said first load element is a resistor ($R_3$).

8. An input buffer circuit according to any one of the preceding claims, characterized in that a capacitor (C) is connected between the input node of said source follower circuit ($Q_1$, $Q_2$) and an input node of said FET inverter circuit ($Q_3$, $Q_4$).

9. An input buffer circuit according to any one of the preceding claims, characterized in that said control voltage ($V_{cont}$) is supplied from a control circuit comprising a second inverter circuit ($Q_3'$, $Q_4'$), which is equivalent to said inverter circuit ($Q_3$, $Q_4$); a second source follower circuit ($Q_1'$, $Q_2'$), which is equivalent to said source follower circuit ($Q_1$, $Q_2$), the gate of said first FET of the second source follower circuit ($Q_1'$) being connected to a predetermined reference voltage, the output of the second source follower circuit being connected to the second inverter circuit ($Q_3'$, $Q_4'$) either directly or through a second level shift circuit; and a third inverter circuit (INV) which receives an output of said second inverter circuit ($Q_3'$, $Q_4'$); an output of the third inverter circuit (INV) being fed back to the gate of said second FET ($Q_2'$) of said second source follower circuit.

10. An input buffer circuit according to claim 9, characterized in that the output of said third inverter circuit (INV) in said control circuit is connected to the gate of said second FET ($Q_2'$) of said second source follower circuit through a level shift circuit (D*, R*).

**Patentansprüche**

1. Eingangspufferschaltung, umfassend eine Inverterstufe ($Q_3$, $Q_4$); eine Source-Folgerstufe mit einem ersten und einem zweiten FET ($Q_1$, $Q_2$) mit gleichem Leitfähigkeitstyp, deren Source-Drain-Strecken in Serie geschaltet sind, wobei die Gate-Elektrode des ersten FETs ($Q_1$) mit einem Schaltungseingang zur Aufnahme des Eingangssignals ($V_{in}$) und der Ausgang der Source-Folgerstufe mit der Inverterstufe ($Q_3$, $Q_4$) entweder direkt oder über eine Pegelverschiebungsstufe ($D_2$, R) verbunden ist, dadurch gekennzeichnet, daß an der Gate-Elektrode des zweiten FETs ($Q_2$) der Source-Folgerstufe eine Steuerspannung ($V_{cont}$) zur Steuerung eines logischen Übergangpegels der Source-Folgerstufe liegt, um Schwankungen des logischen Eingangs-Schwellenwerts ($V_{inTH}$) der Inverterstufe aufgrund von Schwankungen der Schwellenspannung ($V_{TH}$) und/oder Schwankungen der Vorsorgungsspannung ($V_{SS}$) zu kompensieren.

2. Eingangspufferschaltung nach Anspruch 1, dadurch gekennzeichnet, daß die Pegelverschiebungsstufe mindestens eine zwischen dem ersten und dem zweiten FET ($Q_1$, $Q_2$) in Serie liegende Diode ($D_1$) enthält.

3. Eingangspufferschaltung nach Anspruch 1 oder 2, dadurch gekennzeichnet, daß die Pegelverschiebungsstufe mindestens eine zwischen dem Ausgang der Source-Folgerstufe ($Q_1$, $Q_2$) und dem Eingang der Inverterstufe ($Q_3$, $Q_4$) liegende Diode ($D_2$) enthält.

7

4. Eingangspufferschaltung nach einem der vorhergehenden Ansprüche, dadurch gekennzeichnet, daß die FET-Inverterstufe ein erstes Lastelement und einen mit diesem in Serie liegenden vierten FET ($Q_4$) enthält, dessen Gate-Elektrode das Ausgangssignal der Source-Folgerstufe ($Q_1$, $Q_2$) aufnimmt, wobei zwischen dem ersten Lastelement und dem vierten FET ($Q_4$) ein Ausgang abgegriffen ist.

5. Eingangspufferschaltung nach Anspruch 4, dadurch gekennzeichnet, daß das erste Lastelement ein dritter FET ($Q_3$) mit kurzgeschlossenen Source- und Gate-Elektroden ist.

6. Eingangspufferschaltung nach Anspruch 5, dadurch gekennzeichnet, daß die die Source-Folgerstufe ($Q_1$, $Q_2$) und die FET-Inverterstufe ($Q_3$, $Q_4$) bildenden FETen jeweils gleiche Schwellenspannungen aufweisen und die Summe aus der Quadratwurzel eines Gate-Breitenverhältnisses des ersten und des zweiten FETs ($Q_1$, $Q_2$) der Source-Folgerstufe und der Quadratwurzel einer umgekehrten Zahl eines Gate-Breitenverhältnisses des dritten und des vierten FETs ($Q_3$, $Q_4$) der FET-Inverterstufe etwa 2 beträgt.

7. Eingangspufferschaltung nach Anspruch 4, dadurch gekennzeichnet, daß das erste Lastelement ein Widerstand ($R_3$) ist.

8. Eingangspufferschaltung nach einem der vorhergehenden Ansprüche, dadurch gekennzeichnet, daß zwischen dem Eingangsknotenpunkt der Source-Folgerschaltung ($Q_1$, $Q_2$) und einem Eingangsknotenpunkt der FET-Inverterstufe ($Q_3$, $Q_4$) ein Kondensator (C) liegt.

9. Eingangspufferschaltung nach einem der vorhergehenden Ansprüche, dadurch gekennzeichnet, daß die Steuerspannung ($V_{cont}$) aus einer Steuerschaltung stammt, die eine zu der Inverterstufe ($Q_3$, $Q_4$) äquivalente zweite Inverterstufe ($Q_3'$, $Q_4'$); eine zu der Source-Folgerstufe ($Q_1$, $Q_2$) äquivalente zweite Source-Folgerstufe ($Q_1'$, $Q_2'$), wobei die Gate-Elektrode des ersten FET ($Q_1'$) der zweiten Source-Folgerstufe an einer vorgegebenen Bezugsspannung liegt und der Ausgang der zweiten Source-Folgerstufe an die zweite Inverterstufe ($Q_3'$, $Q_4'$) entweder direkt oder über eine zweite Pegelverschiebungsstufe angeschlossen ist; sowie eine dritte Inverterstufe (INV) aufweist, die ein Ausgangssignal der zweiten Inverterstufe ($Q_3'$, $Q_4'$) aufnimmt, wobei ein Ausgang der dritten Inverterstufe (INV) auf die Gate-Elektrode des zweiten FETs ($Q_2'$) der zweiten Source-Folgerstufe rückgekoppelt ist.

10. Eingangspufferschaltung nach Anspruch 9, dadurch gekennzeichnet, daß der Ausgang der dritten Inverterstufe (INV) in der Steuerschaltung an die Gate-Elektrode des zweiten FETs ($Q_2'$) der zweiten Source-Folgerstufe über eine Pegelverschiebungsstufe (D*, R*) angeschlossen ist.

## Revendications

1. Circuit tampon d'entrée comportant un circuit inverseur ($Q_3$, $Q_4$) un circuit à source asservie comprenant des premier et second transistors FET ($Q_1$, $Q_2$) possédant un type de conductivité identique et dont les voies source-drain sont branchées en série, la grille dudit premier transistor FET ($Q_1$) étant raccordée à une entrée du circuit pour recevoir le signal d'entrée ($V_{in}$), la sortie du circuit à source asservie étant raccordée au circuit inverseur ($Q_3$, $Q_4$) soit directement, soit par l'intermédiaire d'un circuit de décalage de niveau ($D_2$, R), caractérisé en ce qu'une tension de commande ($V_{cont}$) est appliquée à la grille dudit second transistor FET ($Q_2$) situé dans ledit circuit à source asservie pour commander un niveau logique de transition dudit circuit à source asservie afin de compenser des variations du seuil logique d'entrée ($V_{inTH}$) du circuit inverseur, dues à des variations de la tension de seuil ($V_{TH}$) et/ou à des variations de la tension d'alimentation ($V_{SS}$).

2. Circuit tampon d'entrée selon la revendication 1, caractérisé en ce que ledit circuit de décalage de niveau comporte au moins une diode ($D_1$), qui est branchée en série entre lesdits premier et second transistors FET ($Q_1$, $Q_2$).

3. Circuit tampon d'entrée selon la revendication 1 ou 2, caractérisé en ce que ledit circuit de décalage de niveau comporte au moins une diode ($D_2$), qui est branchée entre la sortie dudit circuit à source asservie ($Q_1$, $Q_2$) et l'entrée dudit circuit inverseur ($Q_3$, $Q_4$).

4. Circuit tampon d'entrée selon l'une quelconque des revendications précédentes, caractérisé en ce que ledit circuit inverseur à transistors FET comporte un premier élément de charge et un quatrième transistor FET ($Q_4$), qui sont branchés en série, la grille dudit quatrième transistor FET recevant le signal de sortie dudit circuit à source asservie ($Q_1$, $Q_2$), et une sortie est prévue entre ledit premier élément de charge et ledit quatrième transistor FET ($Q_4$).

5. Circuit tampon d'entrée selon la revendication 4, caractérisé en ce que ledit premier élément de charge est un troisième transistor FET ($Q_3$), dont la source et la grille sont raccordées l'une à l'autre.

6. Circuit tampon d'entrée selon la revendication 5, caractérisé en ce que les transistors FET respectifs, qui constituent ledit circuit à source asservie ($Q_1$, $Q_2$), et ledit circuit inverseur à transistors FET ($Q_3$, $Q_4$) possèdent des tensions de seuil égales, et la somme de la racine carrée du rapport des largeurs des grilles desdits premier et second transistors FET ($Q_1$, $Q_2$) dudit circuit à source asservie et de la racine carrée d'un nombre inverse d'un rapport des largeurs des grilles desdits troisième et quatrième transistors FET ($Q_3$, $Q_4$) dudit circuit inverseur à transistors FET est égale approximativement à 2.

7. Circuit tampon d'entrée selon la revendication 4, caractérisé en ce que ledit premier élément de charge est une résistance ($R_3$).

8. Circuit tampon d'entrée selon l'une quelconque des revendications précédentes, caractérisé en ce qu'un condensateur (C) est branché entre le noeud d'entrée dudit circuit à source asservie ($Q_1$, $Q_2$) et un noeud d'entrée dudit circuit inverseur à transistors FET ($Q_3$, $Q_4$).

8

9. Circuit tampon d'entrée selon l'une quelconque des revendications précédentes, caractérisé en ce que ladite tension de commande ($V_{cont}$) est délivrée à partir d'un circuit de commande comprenant un second circuit inverseur ($Q_3'$, $Q_4'$), qui est équivalent audit circuit inverseur ($Q_3$, $Q_4$); un second circuit à source asservie ($Q_1'$ $Q_2'$), qui est équivalent audit circuit à source asservie ($Q_1$, $Q_2$), la grille dudit premier transistor FET du second circuit à source asservie ($Q_1'$) étant placée à une tension de référence prédéterminée, la sortie du second circuit à source asservie étant raccordée au second circuit inverseur ($Q_3'$, $Q_4'$) soit directement, soit par l'intermédiaire d'un second circuit de décalage de niveau; et un troisième circuit inverseur (INV), qui reçoit un signal de sortie dudit second circuit inverseur ($Q_3'$, $Q_4'$); un signal de sortie du troisième circuit inverseur (INV) étant couplé par réaction à la grille dudit second transistor FET ($Q_2'$) dudit second circuit à source asservie.

10. Circuit tampon d'entrée selon la revendication 9, caractérisé en ce que le signal de sortie dudit troisième circuit inverseur (INV) situé dans ledit circuit de commande est raccordé à la grille dudit second transistor FET ($Q_2'$) dudit second circuit à source asservie, par l'intermédiaire d'un circuit de décalage de niveau (D*, R*).

9

FIG. 2

OUTPUT VOLTAGE (V)

0
-0.5
-1
-1.5
-2

-2  -1.8  -1.5 -1.45  -1.15 -1 -0.9  -0.5

INPUT VOLTAGE (V)

←ECL→

a
b
c

FIG. 1

$V_{in}$ o

$V_S$

D

R

o $V_{LL}$

$Q_3$

$Q_4$

o $V_{out}$

o $V_{SS}$

1

FIG. 4

FIG. 3

## FIG. 5

## FIG. 6

FIG. 7

FIG. 8

0 110 701

## FIG. 9

## FIG. 10

## FIG. 11

## FIG. 12

FIG. 14

FIG. 15

FIG. 13

*FIG. 16*

*FIG. 17*

*FIG. 18*